# EUROPÄISCHE PATENTSCHRIFT

(11) **EP 1 862 563 B1**
(45) Veröffentlichungstag und Bekanntmachung des Hinweises auf die Patenterteilung: **30.03.2011**
(21) Anmeldenummer: 07010658.8
(22) Anmeldetag: 30.05.2007
(51) Int. Cl.: C23C 14/14

(54) **Sputterabscheidung von Molybdänschichten**
Sputter deposition of molybdenum layers
Procédé de dépôt de couches de molybdène par pulvérisation cathodique

(30) Priorität: 02.06.2006 DE 102006026672
(43) Veröffentlichungstag der Anmeldung: 05.12.2007
(73) Patentinhaber: Würth Solar GmbH & Co. KG, 71672 Marbach (DE)
(72) Erfinder: Menner, Richard, 70374 Stuttgart (DE); Oertel, Mike, 70176 Stuttgart (DE); Sprecher, Bernd, 74427 Fichtenberg (DE); Dimmler, Bernhard, 74523 Schwäbisch Hall (DE); Bauer, Tino, 74226 Nordheim (DE)
(74) Vertreter: Wilhelm, Martin

(56) Entgegenhaltungen:
- DE-B1- 1 690 276
- US-B1- 6 372 538
- US-B2- 6 974 976

## Beschreibung

Die Erfindung betrifft ein Verfahren zur Sputterdeposition von Molybdänschichten auf natriumhaltige Glassubstrate.

Die Abscheidung großflächiger metallischer Schichten auf Glassubstraten durch Sputtern wird in der Glasbeschichtungsindustrie verbreitet genutzt, beispielsweise für Fensterscheiben mit bestimmten optischen oder thermischen Eigenschaften oder, mit zunehmender Quantität, für Dünnschichtsolarzellen. Speziell bei Dünnschichtsolarzellen sind die Anforderungen in Bezug auf die Homogenität und Stabilität gegenüber nachfolgenden Prozessschritten und auch in Bezug auf eine Langzeitstabilität sehr groß. Die Qualität der abgeschiedenen Schichten kann jedoch in kritischer Weise von den Bedingungen beim Sputtern abhängen, wie beispielsweise die Geometrie der Plasmaumgebung, Abnutzung des Targets und Qualität des Vakuums. Wenigstens einige dieser kritischen Einflussgrößen können durch Verwendung von modifizierten Sputterprozessgasen positiv beeinflusst werden.

Ein metallischer Film, wie beispielsweise Molybdän, wird typischerweise unter Verwendung von Sputterabscheidung auf ein Glassubstrat aufgebracht. Die Sputterdeposition wird allgemein in einer Vakuumkammer durchgeführt, in der ein massives Target des gewünschten Schichtmaterials in der Nähe eines Substrates angebracht ist. Bei einem bestimmten Prozessdruck von Argongas in der Vakuumkammer wird ein elektrisches Feld zwischen dem Target und dem Substrat angelegt, so dass ein Plasma entsteht. In dem Plasma werden Gase ionisiert und entsprechend ihrer positiven Ladung in Richtung auf das Target beschleunigt, das als negativ vorgespannte Kathode wirkt. Während der Beschleunigung erhalten die Ionen einen genügend großen Impuls, um Atome und/oder Moleküle aus der Oberfläche des Targets beim Aufprall auf das Target herauszuschlagen oder "zu sputtern". Nachdem die Atome und/oder Moleküle aus dem Target herausgeschlagen wurden, formen die Argonionen, die herausgeschlagenen Atome/Moleküle, sowie Argonatome und Elektronen, die durch den Sputterprozess erzeugt wurden, einen Plasmabereich vor dem Target, bevor sie sich auf dem Substrat ablagern, das üblicherweise unterhalb oder parallel zu dem Target innerhalb der Vakuumkammer positioniert ist. Die herausgeschlagenen Atome und/oder Moleküle können jedoch in die Vakuumkammer hineingestreut werden, ohne zu der Erzeugung des Plasmabereichs beizutragen und lagern sich infolgedessen nicht auf dem Substrat ab. Dieses Problem wird wenigstens teilweise dadurch gelöst, dass ein sogenanntes Magnetron-Sputtersystem verwendet wird, das Magnete hinter und um das Target herum verwendet. Diese Magneten helfen, das gesputterte Material in dem Plasmabereich zu halten. Das Magnetron-Sputtersystem hat weiterhin den Vorteil, niedrigere Drücke in der Vakuumkammer als andere Sputtersysteme zu benötigen. Ein niedrigerer Druck innerhalb der Vakuumkammer trägt zu einer reineren abgelagerten Schicht bei.

Molybdän wird vorzugsweise als Rückseitenkontakt bei Dünnschichtsolarzellen verwendet, die aus Verbindungen aus Kupfer, Indium, Gallium, Selen oder Schwefel bestehen. Solche Dünnschichtsolarzellen werden als CIGS-Solarzellen bezeichnet, entsprechend Cu (InₓGa₁₋ₓ) (Se_{y}, S_{1-y}) mit 0 ≤ x, y ≤ 1. Molybdän wird als Rückseitenkontakt verwendet, da es eine vergleichsweise große mechanische Härte und eine relativ hohe chemische Beständigkeit aufweist. Trotz seiner generellen Eignung wird Molybdän während des Abscheideprozesses der CIGS-Schichten in der sehr reaktiven Selen- oder Schwefelatmosphäre chemisch modifiziert. Tatsächlich ist die Ausbildung einer dünnen Schicht einer Mo(Se_{y}S_{1-y}) mit 0 ≤ x, y ≤ 1 enthaltenden Phase unerlässlich, um einen guten ohmschen Kontakt mit der CIGS-Schicht herzustellen. Unerwünschte Reaktionen oder eine nachfolgende Verschlechterung der Stabilität können jedoch unter bestimmten Situationen auftreten.

Solarzellen können Sonnenlicht mittels photoelektrisch aktiver Materialien in elektrische Energie umsetzen. Anstatt kristallines Silizium, das klassische Solarzellenmaterial, in Scheiben zu schneiden und diese Scheiben nachfolgend chemisch zu modifizieren und elektrische Kontakte aufzubringen, wird bei der Dünnschichtsolarzellentechnologie die gesamte Abfolge der erforderlichen Kontaktmaterialien oder aktiven Materialien Schicht für Schicht auf einem Substrat abgelagert. Mittels dieser Technologie können großflächige Substrate mit einem gleichzeitig wesentlich reduzierten Materialverbrauch realisiert werden. Neben den Dünnschichtsolarzellenmaterialien amorphes Silizium oder Kadmium Telurid ist der vielversprechendste Kandidat CIGS, da mit diesem Schichtaufbau auf Laborebene Wirkungsgrade von mehr als 19% erreicht werden. CIGS-Schichten werden typischerweise direkt mittels Abscheidung der Elemente aus der Dampfphase, dem sogenannten PVD-Verfahren, bei Temperaturen zwischen 500°C und 600°C aufgebracht. Alternativ können die metallischen Elemente Kupfer, Indium und Gallium in einem ersten Schritt durch Sputterdeposition oder Elektrodeposition oder ähnliches aufgebracht werden, um nachfolgend gesintert und in einem Selenisations- oder Sulforisationsschritt bei ähnlichen Temperaturen chemisch modifiziert zu werden. Für beide Verfahren ist die großflächige Deposition von optimierten metallischen Rückseitenkontakten, in diesem Fall Molybdän, absolut unerlässlich. Die Anforderungen an diese Rückseitenkontaktschicht sind jedoch sehr vielschichtig, unter anderem wird eine hohe elektrische Leitfähigkeit, die gute Ausbildung eines ohmschen Kontaktes, optimierte Substrateigenschaften für die nachfolgende CIGS-Deposition mit einer hervorragenden Adhäsion des kompletten Schichtaufbaus zu dem Glassubstrat, hoch effektive Barrierenwirkung gegen Unreinheiten, die aus dem Glas heraus diffundieren sowie gleichzeitig eine optimierte Regelung der erwünschten Natriumdiffusion von dem Glassubstrat in die CIGS-Schicht gefordert. Weiterhin sollte die Rückseitenkontaktschicht vorzugsweise nur zu kleinen Spannungen in dem Glassubstrat führen und sollte vorzugsweise stabil gegen Umwelteinflüsse sein.

Normalerweise werden bei der Sputterdeposition möglichst reine Metallschichten gewünscht, so dass in die Sputterdepositionskammer Edelgas eingebracht wird, in der Regel Argon, um eine Oxidation der Schichten zu verhindern. Es ist ebenfalls bekannt, dem Edelgas Argon gezielt ein Reaktivgas, meist Stickstoff oder Sauerstoff, hinzuzufügen, um Verbindungen abzuscheiden, die nicht oder nicht hinreichend elektrisch leitfähig sind.

Aus dem US-Patent US 6,372,538 B1 ist ein Verfahren zur Sputterdeposition von Molybdän zur Kontaktierung von Dünnschichtsolarzellen bekannt, wobei auf ein flexibles Kunststoffsubstrat eine Molybdänschicht abgeschieden wird. In eine Sputterdepositionskammer wird erhitzter Wasserdampf und Argon in einer Mischung von 0,1 bis 10 sccm Wasserdampf und 200 sccm Argon eingebracht. Anstelle von Wasserdampf, der zur Bereitstellung von Sauerstoff verwendet wird, kann auch gasförmiger Sauerstoff eingebracht werden. In der Sputterdepositionskammer soll ein Verhältnis von 5:1 bis etwa 50:1 von Argonatomen zu Sauerstoffatomen aufrechterhalten werden.

Aus der deutschen Auslegeschrift DE 16 90 276 A1 ist ein Verfahren zur Sputterdeposition von Molybdänschichten auf Halbleitermaterial, speziell Silizium, bekannt. In die Sputterdepositionskammer soll eine Mischung aus einem Edelgas mit einem geringen Anteil Wasserstoff eingebracht werden. Durch den Wasserstoff soll eine reduzierende Atmosphäre geschaffen werden. Aus Preisgründen soll Argon als Edelgas bevorzugt werden und es wird eine Mischung von 90% Argon und 10% Wasserstoff vorgeschlagen.

Aus dem US-Patent US 6,974,976 B2 ist ein Verfahren zum Herstellen von CIGS-Dünnschichtsolarzellen bekannt.

Mit der Erfindung soll die Sputterdeposition von Molybdän enthaltenden Schichten verbessert werden.

Erfindungsgemäß ist hierzu ein Verfahren zur Sputterdeposition von Molybdänschichten auf natriumhaltige Glassubstrate zur Kontaktierung von CIS- oder CIGS-Dünnschichtsolarzellen in einer Sputterdepositionskammer mit einem Molybdän enthaltenden Target mit folgenden Schritten vorgesehen: Evakuieren der Sputterdepositionskammer, Anlegen eines elektrischen Feldes zwischen das Target und das Substrat Verbessern einer Natrium-Ionendiffussion aus dem Glassubstrat in die Molybdänschicht und Einbauen von Spuren von Wasserstoff in die Molybdänschicht durch Einbringen einer Mischung aus Argon und einem weiteren Gas mit geringerem Volumenanteil als Argon in die Sputterdepositionskammer während des Abscheidens der Molybdänschicht, wobei das weitere Gas eine Wasserstoff und Wasserdampf enthaltende Gasmischung ist.

Es wurde festgestellt, dass das Beimischen von Wasserstoff und Wasserdampf oder Mischungen mit diesen Gasen die Sputterdeposition von Molybdän erheblich verbessert. Speziell das Einbringen von Wasserstoff in die Sputterdepositionskammer beeinflusst sowohl die Plasmaeigenschaften des veränderten Plasmas als auch die Eigenschaften der abgeschiedenen Molybdänschicht in vorteilhafter Weise. Im speziellen Fall von Dünnschichtsolarzellen und insbesondere bei CIS- oder CIGS-Solarzellen, kann das Vorhandensein von Wasserstoff und Wasserdampf den Schichtenverbund der Solarzelle positiv beeinflussen.

Mit dem erfindungsgemäßen Verfahren, bei dem Wasserstoff gemeinsam mit Argon in eine Sputterdepositionskammer während der Sputterdeposition von Molybdän auf ein Substrat eingebracht wird, können Molybdän enthaltende Schichten beispielsweise auf Glas, Edelstahl, Titan, Kunststoff oder dergleichen abgeschieden werden, die die gestellten Anforderungen erfüllen.

In Weiterbildung der Erfindung liegt das Volumenverhältnis zwischen Argon und dem weiteren Gas zwischen etwa 1:0,01 und etwa 1:0,1.

Bereits geringe Anteile von insbesondere Wasserstoff reichen aus, um die Sputterdeposition von Molybdänschichten erheblich zu verbessern. Vorteilhafterweise liegt eine Zuführrate von Argon zwischen 5 und 1500 Standardkubikzentimer pro Minute (sccm) und eine Zuführrate des weiteren Gases liegt zwischen 1 und 300 sccm. Eine Prozesstemperatur in der Sputterdepositionskammer liegt vorteilhaft zwischen 20°C und 150°C. In der Sputterdepositionskammer liegt eine Energiedichte zwischen Kathode und Anode vorteilhafterweise zwischen etwa 1 W/cm² und 20 W/cm². Ein Prozessdruck in der Sputterdepositionskammer liegt vorteilhafterweise zwischen 1 µbar und 25 µbar. Mit dem erfindungsgemäßen Verfahren wird ein Glassubstrat mit einer Molybdän enthaltenden Schicht auf dem Substrat, insbesondere eine Dünnschichtsolarzelle, bereitgestellt, bei der die Molybdänschicht Spuren von Wasserstoff enthält, wobei der Wasserstoffgehalt weniger als 0,1 Atomprozent beträgt und die Molybdänschicht mittels Sputterdeposition unter Einbringen einer Mischung aus Argon und einer Wasserstoff und Wasserdampf enthaltenden Gasmischung mit geringerem Volumenanteil als Argon aufgebracht wurde und die Molybdänschicht gegenüber einer ohne Vorhandensein der Wasserstoff und Wasserdampf enthaltenden Gasmischung aufgebrachten Molybdänschicht einen leichten Überschuss an Wasserstoffionen und eine erhöhte Natriumkonzentration aufweist.

Es wird angenommen, dass Spuren von Wasserstoff in der Molybdänschicht speziell beim CIGS-Prozess zur Herstellung von Dünnschichtsolarzellen Diffusionseffekte zwischen dem Substrat, der Molybdänschicht sowie den photoelektrisch aktiven Schichten unterstützen kann. Mit CIGS wird ein Schichtaufbau aus Kupfer, Indium, Gallium, Selen oder Schwefel bezeichnet, wobei Selen oder Schwefel eingesetzt werden kann und wobei als Rückseitenkontakt dieses Schichtaufbaus Molybdän verwendet wird. Das Substrat kann Kalk-Natron-Glas, sogenanntes Sodalimeglas, aufweisen. Das Substrat kann aber auch aus Kunststoff, insbesondere Polyamid, Titan oder Stahl, insbesondere Edelstahl, hergestellt sein. Das Substrat kann flexibel ausgebildet sein.

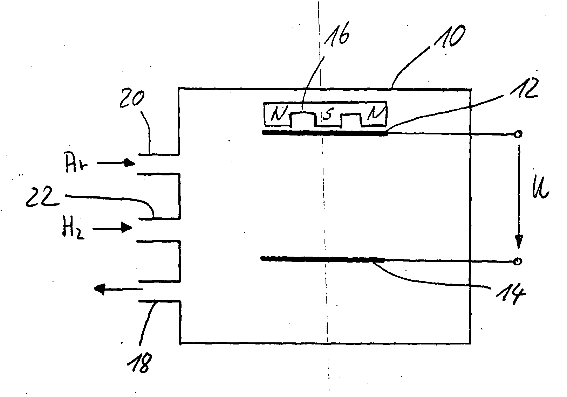

Weitere Merkmale und Vorteile der Erfindung ergeben sich aus der nachstehenden Beschreibung einer bevorzugten Ausführungsform der Erfindung im Zusammenhang mit der Zeichnung sowie aus den Ansprüchen. In der Zeichnung zeigt:
Die einzige Figur eine schematische Darstellung einer Sputterdepositionskammer für das erfindungsgemäße Verfahren.

Die einzige Figur zeigt schematisch eine Sputterdepositionskammer 10, in der ein sogenanntes Target 12 aus Molybdän und ein Substrat 14 angeordnet sind. Auf einer, dem Substrat 14 abgewandten Seite des Targets 12 kann ein sogenanntes Magnetron 16 angeordnet sein. Durch das vom Magnetron 16 erzeugte Magnetfeld werden geladene Teilchen in der Sputterdepositionskammer 10 auf Spiralbahnen abgelenkt, wodurch deren Weg verlängert und die Zahl der Ionisationsvorgänge erhöht wird. Das Vorhandensein des Magnetron 16 ist aber nicht zwingende Voraussetzung für die Durchführung des erfindungsgemäßen Verfahrens.

Um die Sputterdepositionskammer 10 zu evakuieren ist ein Auslass 18 vorgesehen, der mit einer nicht dargestellten Vakuumpumpe verbunden ist. Während der Molybdänabscheidung wird das Innere der Sputterdepositionskammer 10 vorteilhafterweise auf einem Druck zwischen 1,0 µbar und 25 µbar gehalten. Über einen Einlass 20 kann das Edelgas Argon in das Innere der Sputterdepositionskammer 10 eingebracht werden, wobei mittels nicht dargestellter Ventile ein Zustrom von Argon in weiten Grenzen einstellbar ist. Über einen Einlass 22 kann Wasserstoff in die Sputterdepositionskammer eingebracht werden, wobei auch der Zustrom von Wasserstoff mittels einstellbarer Ventile in weiten Grenzen einstellbar ist. Es ist dabei festzuhalten, dass Argon und Wasserstoff auch bereits vor dem Einbringen in die Sputterdepositionskammer gemischt werden können.

Ein Zustrom an Argon in die Sputterdepositionskammer wird zwischen 100 und 1500 Standardkubikzentimetern pro Minute (sccm) gehalten und ein Zustrom an Wasserstoff wird auf einer Rate zwischen 10 und 100 sccm gehalten. Wenn eine vorbereitete Argon/Wasserstoffmischung in die Sputterdepositionskammer 10 eingebracht wird, wird eine Rate zwischen 100 und 1500 sccm eingehalten. Zwischen dem Target 12 und dem Substrat 14 wird eine Gleichspannung U angelegt, so dass sich eine Gleichstromleistungsdichte zwischen etwa 1 W/cm² und 20 W/cm² zwischen Kathode, in diesem Fall das Molybdäntarget 12, und der Anode, in diesem Fall das Substrat 14, einstellt.

Das Substrat 14 kann aus sogenanntem Sodalimeglas, Kalk-Natron-Glas, bestehen, die Ablagerung von Molybdänschichten ist aber auch auf Kunststoffen oder auf Titan oder Edelstahl möglich. Das Substrat 14 kann dabei durchaus flexibel sein, beispielsweise wenn Dünnschichtsolarzellen auf eine Kunststofffolie aufgebracht werden sollen.

Während des Aufbringens der photoelektrisch aktiven Schichten können verschiedene Effekte zu einer Verschlechterung der entstehenden Solarzellen führen, wenn der Molybdänrückseitenkontakt nicht optimal aufgebracht ist. Zum einen können Verschmutzungen auf dem Substrat selbst vorhanden sein. Auch wenn Glassubstrate typischerweise in einem nasschemischen Prozess und/oder zusätzlich durch Plasmabehandlung vor dem Abscheiden des Rückseitenkontaktes gereinigt werden, können immer noch unvermeidbare Verschmutzungen beim Herstellen des Glases auftreten, beispielsweise verbleibende Verschmutzungen von Transportbändern oder Vakuumhandhabungsgeräten, die teilweise lokal nach dem Aufbringen der photoelektrisch aktiven Schichten noch sichtbar sind und die von einer Veränderung der Adhäsionseigenschaften, der Morphologie und der Kristallstruktur in diesen Bereichen herrühren. Zum anderen können geometrische Abmessungen des Targets teilweise zu einer Verschlechterung der Molybdänschicht und in der Folge zu einer Verschlechterung des gesamten Schichtaufbaus in den von den Eckbereichen des Targets beeinflussten Regionen führen. Beide nachteilige Effekte können wirksam durch das erfindungsgemäß vorgeschlagene Verfahren vermieden werden, bei dem eine Sputtergasmischung aus Argon und Wasserstoff eingesetzt wird.

Es wird dabei davon ausgegangen, dass das Hinzufügen kleiner Mengen von Wasserstoff in der Hauptsache die Plasmaeigenschaften wie Energiegehalt und geometrische Ausdehnung des Plasmas beeinflusst. Dies verändert wiederum die Sputterrate und den geometrischen Winkel der einfallenden Sputterpartikel in den Eckbereichen und dergleichen. Beispielsweise wird für die Dissoziation von Wasserstoffmolekülen Energie benötigt, so dass dadurch der Energiegehalt des Plasmas verändert wird. Weiterhin verändern die Wasserstoffmoleküle oder Atome auch die Beschleunigung und das Aufprallverhalten der gesamten Gasmischung während des Sputteringprozesses und beeinflussen dadurch beispielsweise die Sputterrate und weitere Kenngrößen.

Gemäß der vorliegenden Erfindung wird eine an und für sich konventionelle Magnetron-Sputterdepositionskammer mit den folgenden Prozessparametern betrieben:

| | |
|---|---|
| Energiedichte (Gleichstrom) | zwischen etwa 1 und 20 W/cm² |
| Druck in der Vakuumkammer | zwischen etwa 1,0 und 25 µbar |
| Argongaszuführrate | zwischen etwa 10 und 1500 sccm |
| Wasserstoff-Gaszuführrate | zwischen etwa 1 und 300 sccm |
| Argon-/Wasserstoffverhältnis | zwischen etwa 1:0,01 bis 1: 0,1. |

Der Betrieb der Magnetron-Sputterdepositionskammer 10 erfordert allgemein das Anlegen der Gleichstromspannung zwischen der Kathode, in diesem Fall das Molybdäntarget 12, und der Anode, das Substrat 14 oder eine zusätzliche Elektrode, um das Plasma zu erzeugen. Die Kammer 10 wird innerhalb des oben genannten Druckbereichs gehalten und eine geeignete Mischung aus Argon und Wasserstoff wird zugeführt. Die Molybdän enthaltenden Schichten, die sich dann ergeben, haben eine Dicke zwischen etwa 0,1 bis 2 µm und einen Flächenwiderstand von etwa 0,1 bis 1,0 Ohmquadrat bei einer Dicke von 1 µm. Es wird angenommen, dass der primäre Mechanismus zur Verbesserung der Molybdänschicht und somit der CIGS-Solarzellenqualität das Vorhandensein von Wasserstoff in dem System ist, der die Plasmaumgebung des Targets 12 in wünschenswerter Weise verändert.

Während der Wasserstoff selbst in der Molybdänschicht nicht messbar ist, da der Wasserstoffgehalt unter der derzeit realisierbaren Nachweisgrenze von 0,1 Atomprozent, entsprechend einem Atom Wasserstoff auf 1000 Atome oder 0,1 at%, kann teilweise eine erhöhte Menge an Sauerstoff und Natrium in der Molybdänschicht detektiert werden, aber nicht notwendigerweise in der CIGS-Schicht darauf. Es wird angenommen, dass eine Natrium-Ionendiffusion aus dem Glassubstrat einen lonenaustausch erfordert, um den Ladungsausgleich aufrecht zu erhalten. Wasserstoffionen H+ sind ein idealer Diffusionspartner für Natriumionen Na+, so dass angenommen wird, dass ein leichter Überschuss an Wasserstoffionen die Natriumkonzentration in der Molybdänschicht erhöht, was sich vorteilhaft auf den nachfolgenden CIGS-Prozess auswirkt.

Nachfolgend sollen drei Beispiele zur Verdeutlichung der Erfindung erläutert werden:

### BEISPIEL 1

Ein Vergleichsprobe einer Molybdänschicht auf einem Sodalimeglas, sogenanntes Kalk-Natron-Glas, wurde in einer für den Stand der Technik beispielhaften Weise, d.h. ohne Vorhandensein von Wasserstoffgas, erzeugt. Verwendet wurde ein Durchlauf-Gleichstrom-Sputtersystem, um das Molybdän von einem Molybdäntarget auf das Kalk-Natron-Glassubstrat abzuscheiden. Der Abscheideprozess wurde bei einem Basisdruck von 5 x 10⁻⁶ mbar und einem Prozessdruck von 2,5 x 10⁻⁶ mbar bei einer Argonzuführrate von 300 sccm bei einer Energiedichte von 6 W/cm² und einer Substratbewegungsgeschwindigkeit von 6 mm/s durchgeführt. Die sich ergebende Molybdän enthaltende Schicht hatte eine Dicke von etwa 350 nm und einen Flächenwiderstand von 0,5 Ohmquadrat.

Die Messungen für die kennzeichnenden Parameter und Eigenschaften wurden wie folgt durchgeführt:

| | |
|---|---|
| Dicke | - Röntgenfluoreszenz-Spektroskopie, Elektronenscan-Mikroskopie |
| Elektrischer Widerstand | - Vierpunktmessung. |

Die Vergleichsprobe wurde unmittelbar nach dem Öffnen und Belüften und nachfolgendem Verschließen und erstmaligem Abpumpen der Vakuumkammer hergestellt. In diesem Zustand, also kurz nach Öffnen und Belüften der Kammer, zeigt eine Emissionsspektroskopie einen Wasserstoffpeak neben dem Argon und anderen Restgasarten.

Bei dieser Vergleichsprobe konnten leichte Adhäsionsfehler nach dem nachfolgenden CIGS-Prozess in den Eckenregionen festgestellt werden.

### BEISPIEL 2

Eine weitere Vergleichsprobe wurde unter den Bedingungen gemäß Beispiel 1, das heißt ebenfalls ohne Vorhandensein von Wasserstoffgas hergestellt, im Unterschied zu Beispiel 1 aber erst dann, nachdem die Vakuumkammer bereits für längere Zeit abgepumpt wurde. In diesem Fall zeigte eine Emissionsspektroskopie, einen gegenüber dem Argon und anderen Restgasarten wesentlich kleineren Wasserstoffpeak.

Durch optische Inspektion konnten bei der Vergleichsprobe gemäß Beispiel 2 im Vergleich zu Beispiel 1 schwerere Adhäsionsfehler nach dem nachfolgenden CIGS-Prozess in den Eckenregionen festgestellt werden.

### BEISPIEL 3

Eine Probe einer Molybdänschicht auf einem Kalk-Natronglas-Substrat wurde gemäß dem Verfahren nach der vorliegenden Erfindung hergestellt, mit im Wesentlichen denselben Prozeduren des Sputtersystems wie bei den Vergleichsproben, die zuvor diskutiert wurden, mit der Ausnahme, dass das Belüftungsgas für die Hauptabscheidekammer Argon und Wasserstoff enthielt. Es konnte festgestellt werden, dass die optische Erscheinung und auch die Qualität der vollständig fertiggestellten Solarzellenmodule klar gegenüber dem Herstellprozess ohne Hinzufügen von Wasserstoff zu Argon verbessert wurde.

Bei Durchführen einer Emissionsspektroskopie kann ein deutlicher Wasserstoffpeak festgestellt werden. Dies lässt den Schluss zu, dass das Hinzufügen von Wasserstoff, Wasserdampf oder Wasserstoff und/oder Wasserdampf enthaltenden Gasmischungen zu dem Sputtergas Argon die Qualität der abgeschiedenen Molybdänschicht deutlich verbessert. Es ist daher sinnvoll, zusammen mit dem Sputtergas eine festgelegte Menge an Wasserstoff konstant zuzuführen.

## Patentansprüche

1. Verfahren zur Sputterdeposition von Molybdänschichten auf natriumhaltigen Glassubstraten zur Kontaktierung von CIS- oder CIGS-Dünnschichtsolarzellen, in einer Sputterdepositionskammer mit einem Molybdän enthaltenden Target (12) mit folgenden Schritten: Evakuieren der Sputterdepositionskammer (10), Anlegen eines elektrischen Feldes zwischen dem Target (12) und dem Substrat (14), **gekennzeichnet durch** Verbessern einer Natrium-Ionendiffusion aus dem Glassubstrat in die Molybdänschicht und Einbauen von Spuren von Wasserstoff in die Molybdänschicht **durch** Einbringen einer Mischung aus Argon und einem weiteren Gas mit geringerem Volumenanteil als Argon in die Sputterdepositionskammer (10) während des Abscheidens der Molybdänschicht, wobei das weitere Gas eine Wasserstoff (H₂) und Wasserdampf (H₂O) enthaltende Gasmischung ist.

2. Verfahren nach Anspruch 1, **dadurch gekennzeichnet, dass** das Volumenverhältnis zwischen Argon und dem weiteren Gas zwischen etwa 1:0,01 und etwa 1:0,1 liegt.

3. Verfahren nach wenigstens einem der vorstehenden Ansprüche, **dadurch gekennzeichnet, dass** eine Zuführrate von Argon zwischen 5 und 1500 Standardkubikzentimeter pro Minute (sccm) liegt und eine Zuführrate des weiteren Gases zwischen 1 und 300 sccm liegt.

4. Verfahren nach wenigstens einem der vorstehenden Ansprüche, **dadurch gekennzeichnet, dass** eine Prozesstemperatur in der Sputterdepositionskammer (10) zwischen 20°C und 150°C liegt.

5. Verfahren nach wenigstens einem der vorstehenden Ansprüche, **dadurch gekennzeichnet, dass** in der Sputterdepositionskammer (10) eine Energiedichte zwischen Kathode und Anode zwischen etwa 1W/cm² und 20 W/cm² liegt.

6. Verfahren nach wenigstens einem der vorstehenden Ansprüche, **dadurch gekennzeichnet, dass** in der Sputterdepositionskammer (10) ein Prozessdruck zwischen 1 µbar und 25 µbar anliegt.

## Claims

1. Method for sputter deposition of molybdenum layers onto sodium-containing glass substrates for contacting of CIS or CIGS thin-film solar cells inside a sputter deposition chamber with a molybdenum-containing target (12) having the following steps: evacuation of the sputter deposition chamber (10) and application of an electrical field between the target (12) and the substrate (14), **characterized by** improvement of a sodium ion diffusion from the glass substrate into the molybdenum layer and by incorporation of traces of hydrogen into the molybdenum layer by introducing into the sputter deposition chamber (10) a mixture of argon and a further gas having a lower proportion by volume than argon during deposition of the molybdenum layer, the further gas being a gas mixture containing a hydrogen (H₂) and steam (H₂O).

2. Method according to Claim 1, **characterized in that** the volume ratio between argon and the further gas is between about 1:0.01 and about 1:0.1.

3. Method according to at least one of the preceding claims, **characterized in that** an inflow rate of argon is between 5 and 1500 standard cubic centimeters per minute (sccm), and an inflow rate of the further gas is between 1 and 300 sccm.

4. Method according to at least one of the preceding claims, **characterized in that** a process temperature inside the sputter deposition chamber (10) is between 20°C and 150°C.

5. Method according to at least one of the preceding claims, **characterized in that** inside the sputter deposition chamber (10) an energy density between the cathode and the anode is between about 1 W/cm² and 20 W/cm².

6. Method according to at least one of the preceding claims, **characterized in that** inside the sputter deposition chamber (10) a process pressure between 1 µbar and 25 µbar is applied.

## Revendications

1. Procédé de dépôt de couches de molybdène par pulvérisation cathodique sur des substrats de verre sodiques pour la mise en contact de cellules solaires à couche mince CIS ou CIGS dans une chambre de dépôt par pulvérisation cathodique avec une cible (12) contenant du molybdène, comprenant les étapes suivantes : mise sous vide de la chambre de dépôt par pulvérisation cathodique (10), création d'un champ électrique entre la cible (12) et le substrat (14), **caractérisé par** une meilleure diffusion des ions sodium du substrat de verre dans la couche de molybdène et par l'insertion de traces d'hydrogène dans la couche de molybdène par apport d'un mélange d'argon et d'un autre gaz d'une part volumique plus faible que l'argon dans la chambre de dépôt par pulvérisation cathodique (10) pendant le dépôt de la couche de molybdène, sachant que l'autre gaz est un mélange gazeux contenant de l'hydrogène (H₂) et de la vapeur d'eau (H₂O).

2. Procédé selon la revendication 1, **caractérisé en ce que** le rapport volumique entre l'argon et l'autre gaz est compris entre environ 1:0,01 et environ 1:0,1.

3. Procédé selon au moins l'une des revendications précédentes, **caractérisé en ce qu'**un débit d'argon est compris entre 5 et 1500 centimètres cubes standard par minute (sccm) et un débit de l'autre gaz entre 1 et 300 sccm.

4. Procédé selon au moins l'une des revendications précédentes, **caractérisé en ce qu'**une température de procédé dans la chambre de dépôt par pulvérisation cathodique (10) est comprise entre 20 °C et 150 °C.

5. Procédé selon au moins l'une des revendications précédentes, **caractérisé en ce qu'**une densité énergétique entre cathode et anode est comprise entre environ 1 W/cm² et 20 W/cm² dans la chambre de dépôt par pulvérisation cathodique (10).

6. Procédé selon au moins l'une des revendications précédentes, **caractérisé en ce qu'**une pression de procédé comprise entre 1 µbar et 25 µbars est appliquée dans la chambre de dépôt par pulvérisation cathodique (10).
